(19) Europäisches Patentamt
European Patent Office
Office européen des brevets

(11) EP 4 680 000 A1

(12) EUROPEAN PATENT APPLICATION
published in accordance with Art. 153(4) EPC

(43) Date of publication:
14.01.2026 Bulletin 2026/03

(21) Application number: 24770313.5

(22) Date of filing: 07.02.2024

(51) International Patent Classification (IPC):
H10N 35/80 (2023.01)          C30B 29/62 (2006.01)
C30B 33/00 (2006.01)          H10N 35/01 (2023.01)

(52) Cooperative Patent Classification (CPC):
C30B 29/62; C30B 33/00; H10N 35/01; H10N 35/80

(86) International application number:
PCT/JP2024/004133

(87) International publication number:
WO 2024/190195 (19.09.2024 Gazette 2024/38)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 10.03.2023 JP 2023037128

(71) Applicants:
• Sumitomo Metal Mining Co., Ltd.
Tokyo 105-8716 (JP)
• Yamanashi Prefecture
Kofu-shi, Yamanashi 400-8501 (JP)

(72) Inventors:
• OKUBO, Kazuhiko
Ome-shi, Tokyo 198-8601 (JP)
• IZUMI, Kiyoshi
Ome-shi, Tokyo 198-8601 (JP)
• YATSUSHIRO, Koji
Fujiyoshida-shi, Yamanashi 403-0004 (JP)
• MOCHIZUKI, Yosuke
Fujiyoshida-shi, Yamanashi 403-0004 (JP)

(74) Representative: Müller-Boré & Partner
Patentanwälte PartG mbB
Friedenheimer Brücke 21
80639 München (DE)

(54) MAGNETOSTRICTIVE MEMBER AND PRODUCTION METHOD FOR MAGNETOSTRICTIVE MEMBER

(57)     [Problem] Provided is a magnetostrictive member that provides large device output and reduce a variation in optimum magnetic field strength in device characteristics when the magnetostrictive member with a large parallel magnetostriction amount and a small variation in the parallel magnetostriction amount among members is incorporated into a magnetostrictive vibration power generation device.

[Solution] A magnetostrictive member includes a plurality of magnetostrictive members obtained from the same crystal, the magnetostrictive member being formed of a crystal of an iron-based alloy having magnetostrictive characteristics, being a plate-shaped body having a long-side direction and a short-side direction, and having a plurality of grooves extending in the long-side direction on at least one surface of a front surface and a back surface of the plate-shaped body, and the magnetostrictive members having a ratio (standard deviation/average value) of a standard deviation of optimum magnetic field strength to an average value of the optimum magnetic field strength determined by electromechanical equivalent circuit analysis of 0.2 or less.

Fig. 1

**Description**

Technical Field

The present invention relates to a magnetostrictive member and a method for manufacturing a magnetostrictive member.

Background Art

Magnetostrictive materials are attracting attention as functional materials. For example, Fe-Ga alloys, which are iron-based alloys, are materials exhibiting the magnetostrictive effect and the inverse magnetostrictive effect, showing a large magnetostriction of about 100 to 350 ppm. For this reason, in recent years, they have attracted attention as a material for vibration power generation in the energy harvesting field and are expected to be applied to wearable terminals and sensors. As a method for manufacturing a single crystal of an Fe-Ga alloy, a method for growing a single crystal by the pull-up method (the Czochralski method, hereinafter abbreviated as the "Cz method") is known (e.g., Patent Literature 1). In addition, as methods of manufacture other than the Cz method, the vertical Bridgman method (the VB method) and the vertical temperature gradient freeze method (the VGF method) are known (e.g., Patent Literature 2 and Patent Literature 3).

The Fe-Ga alloy has an easy axis of magnetization in the <100> orientation of the crystal and can exhibit large magnetic distortion in this orientation. Conventionally, magnetostrictive members of the Fe-Ga alloy have been manufactured by cutting a single crystal part oriented in the <100> orientation from an Fe-Ga polycrystal to a desired size (e.g., Non-Patent Literature 1); crystal orientation significantly affects magnetostrictive characteristics, and thus a single crystal in which the direction in which the magnetostriction of magnetostrictive members is required and the <100> orientation, in which the magnetic strain of the crystal is maximum, are matched with each other is considered to be optimum for the material of magnetostrictive members.

The single crystal of the Fe-Ga alloy exhibits positive magnetostriction when a magnetic field is applied in parallel to the <100> orientation of the single crystal (hereinafter referred to as a "parallel magnetostriction amount"). On the other hand, when a magnetic field is applied perpendicularly to the <100> orientation, negative magnetostriction is exhibited (hereinafter referred to as a "perpendicular magnetostriction amount"). As the strength of the applied magnetic field is gradually increased, the parallel magnetostriction amount or the perpendicular magnetostriction amount is saturated. A magnetostriction constant ($3/2\lambda_{100}$) is determined by the difference between the saturated parallel magnetostriction amount and the saturated perpendicular magnetostriction amount and is given by Expression (A) below (e.g., Patent Literature 4 and Non-Patent Literature 2).

$$3/2\lambda_{100} = \varepsilon(//) - \varepsilon(\perp) \quad \cdots \text{Expression (A)}$$

$3/2\lambda_{100}$: the magnetostriction constant
$\varepsilon(//)$: the parallel magnetostriction amount when saturated with a magnetic field applied in parallel to the <100> direction
$\varepsilon(\perp)$: the perpendicular magnetostriction amount when saturated with a magnetic field applied perpendicularly to the <100> direction

The magnetostrictive characteristics of the Fe-Ga alloy are considered to affect the magnetostrictive and inverse magnetostrictive effects and the characteristics of magnetostrictive vibration power generation devices and are important parameters for device design (e.g., Non-Patent Literature 4). In particular, the magnetostriction constant depends on the Ga composition of the Fe-Ga alloy single crystal, and it is known that the magnetostriction constant reaches its maximum at Ga compositions of 18 to 19 at% and 27 to 28 at% (e.g., Non-Patent Literature 2), and it is desirable to use Fe-Ga alloys with such Ga concentrations for devices. Furthermore, in recent years, it has been reported that, in addition to the magnetostriction constant being large, a larger parallel magnetostriction amount tends to result in higher device characteristics such as output voltage (e.g., Non-Patent Literature 3).

A magnetostrictive vibration power generation device, for example, includes an Fe-Ga magnetostrictive member wound on a coil, as well as a yoke and a field permanent magnet (e.g., Patent Literature 5 and Non-Patent Literature 4). This magnetostrictive vibration power generation device has a mechanism in which, when the yoke as a movable part of the device is vibrated, the Fe-Ga magnetostrictive member fixed at the center of the yoke vibrates in tandem, the magnetic flux density of the coil wound on the Fe-Ga magnetostrictive member changes due to the inverse magnetostriction effect, and electromagnetic induction electromotive force is generated to generate power. In the magnetostrictive vibration power generation device, a force is applied in the long-side direction of the yoke to cause vibration, and thus the Fe-Ga magnetostrictive member for use in the device is desirably processed such that <100>, which is the easy axis of magnetization, is in the long-side direction.

Citation List

Patent Literature

[Patent Literature 1] Japanese Patent Application Laid-open No. 2016-28831
[Patent Literature 2] Japanese Patent Application Laid-open No. 2016-138028
[Patent Literature 3] Japanese Patent Application Laid-open No. H4-108699
[Patent Literature 4] Translation of PCT Application No. 2015-517024
[Patent Literature 5] WO2021/158473
[Patent Literature 6] WO2021/100467
[Patent Literature 7] Japanese Patent Application Laid-open No. 2020-63997

Non Patent Literature

[Non-Patent Literature 1] Etrema, State of the Art of Galfenol Processing.
[Non-Patent Literature 2] A. E. Clark et al., Appl. Phys. 93 (2003) 8621.
[Non-Patent Literature 3] Jung Jin Park, Suok-Min Na, Ganesh Raghunath, and Alison B. Flatau., AIP Advances 6, 056221 (2016).
[Non-Patent Literature 4] Toshiyuki Ueno, Journal of the Japan Society for Precision Engineering Vol. 79, No. 4, (2013) 305-308.
[Non-Patent Literature 5] Journal of Marine Acoustics Society of Japan, Vol. 24, No. 3 (1997)

Summary of Invention

Technical Problem

The device characteristics of magnetostrictive vibration power generation devices or the like are affected by the magnetostrictive characteristics of the magnetostrictive member, and thus the magnetostrictive member is required to have high magnetostrictive characteristics and a small variation in the magnetostrictive characteristics. Given these circumstances, it has been believed that if the crystal orientation of the single crystal of the Fe-Ga alloy is <100> and the Ga concentration is uniform, a magnetostrictive member with a uniform magnetostriction constant can be obtained. However, as described in Non-Patent Literature 3, it is disclosed that the device characteristics are affected by the parallel magnetostriction amount as well as the magnetostriction constant. In this context, Patent Literature 6 discloses that by adding a plurality of grooves, for example, grinding marks, extending in the long-side direction of the magnetostrictive member, magnetostrictive members with a high magnetostriction constant and a high parallel magnetostriction amount and a small variation in the magnetostriction constant and the parallel magnetostriction amount among the members can be obtained. When such magnetostrictive members are incorporated into magnetostrictive vibration power generation devices as described above and their device characteristics are checked, it is confirmed that certain device output (e.g., a power generation amount such as a force coefficient) is obtained and that there is a small variation in the device output among the devices.

Still, the magnetic flux density of a magnet to be incorporated into the device must be appropriately set to maximize the device output (power generation amount). In detail, it is necessary to achieve a magnetic flux density (hereafter referred to as the optimum magnetic field strength) that is around half the maximum parallel magnetostriction amount of the magnetostrictive material to be incorporated into the device.

The magnetostrictive vibration power generation device including the magnetostrictive member of Patent Literature 6 involves a large variation in the optimum magnetic field strength of the magnetostrictive material and thus requires adjustment of the magnet strength (the magnetic flux density) for each device in order to improve the device output, which reduces productivity.

Given these circumstances, an object of the present invention is to provide a magnetostrictive member and a method for manufacturing a magnetostrictive member that provide large device output and a reduced variation in optimum magnetic field strength in device characteristics when the magnetostrictive member with a high parallel magnetostriction amount and a small variation in the parallel magnetostriction amount among members is incorporated into the magnetostrictive vibration power generation device.

Solution to Problem

An aspect of the present invention provides a magnetostrictive member including a plurality of magnetostrictive members obtained from the same crystal, the magnetostrictive member being formed of a crystal of an iron-based alloy having magnetostrictive characteristics, being a plate-shaped body having a long-side direction and a short-side direction, and having a plurality of grooves extending in the long-side direction on at least one surface of a front surface and a back surface of the plate-shaped body, and the magnetostrictive members having a ratio (standard deviation/average value) of a standard deviation of optimum magnetic field strength to an average value of the optimum magnetic field strength determined by electromechanical equivalent circuit analysis of 0.2 or less.

The magnetostrictive members may have a ratio (standard deviation/average value) of a standard deviation of a force coefficient to an average value of the force coefficient determined by electromechanical equivalent circuit analysis of 0.3 or less. The magnetostrictive members may have a ratio (standard deviation/average value) of a standard deviation of a force coefficient to an average value of the force coefficient determined by electromechanical equivalent circuit analysis of 0.1 or less.

Also provided is a magnetostrictive member including a plurality of magnetostrictive members obtained from the same crystal, the magnetostrictive member being formed of a crystal of an iron-based alloy having magnetostrictive characteristics, and being a plate-shaped body having a long-side direction and a short-side direction, and the magnetostrictive members having a ratio (standard deviation/average value) of a standard deviation of optimum magnetic field strength to an average value of the optimum magnetic field strength determined by electromechanical equivalent circuit analysis of 0.2 or less, and having a ratio (standard deviation/average value) of a standard deviation of a force coefficient to an average value of the force coefficient determined by electromechanical equivalent circuit analysis of 0.3 or less. The thickness of the plate-shaped body may be 0.3 mm or more and 5 mm or less.

An aspect of the present invention can provide a method for manufacturing the magnetostrictive member of the above aspect including: forming a plurality of grooves, on at least one surface of a front surface and a back surface of a plate-shaped body formed of a crystal of an iron-based alloy having magnetostrictive characteristics and having a long-side direction and a short-side direction, the grooves extending in the long-side direction; and performing heat treatment on the plate-shaped body provided with the grooves extending in the long-side direction.

The grooves may be formed by surface grinding. The heat treatment temperature of the heat treatment may be 400°C or higher and 700°C or lower. The heat treatment retention time of the heat treatment may be 5 hours or less. Reforming a plurality of grooves extending in the long-side direction on the plate-shaped body subjected to the heat treatment may be included.

Effects of Invention

The aspects of the present invention can provide a magnetostrictive member and a method for manufacturing a magnetostrictive member that provide large device output and can reduce a variation in optimum magnetic field strength in device characteristics when a magnetostrictive vibration power generation device is manufactured using the magnetostrictive member with a high parallel magnetostriction amount and a small variation in the parallel magnetostriction amount among members.

Brief Description of the Drawings

[Fig. 1] Fig. 1 is a diagram of an example of a magnetostrictive member according to an embodiment.
[Fig. 2] Fig. 2 is a diagram of an example of a change in a B-H curve in the magnetostrictive member when stress is applied.
[Fig. 3] Fig. 3 is a diagram of an example of an impedance measurement apparatus.
[Fig. 4] Fig. 4 is a diagram of an electromechanical equivalent circuit of a measurement coil.
[Fig. 5] Fig. 5 is a flowchart of an example of a method for manufacturing a magnetostrictive member according to the embodiment.
[Fig. 6] Fig. 6 is a diagram of an example of a single crystal and a thin plate member.
[Fig. 7] Fig. 7 is a flowchart of an example of performing groove re-forming after heat treatment in the method for manufacturing a magnetostrictive member according to the embodiment.

Description of Embodiments

The following gives a description with reference to the accompanying drawings. Part or the whole of each of the drawings is schematically described and is described on different scales as appropriate.

[Embodiment]

The following describes a magnetostrictive member and a method for manufacturing a magnetostrictive member of the present embodiment.

(Magnetostrictive Member)

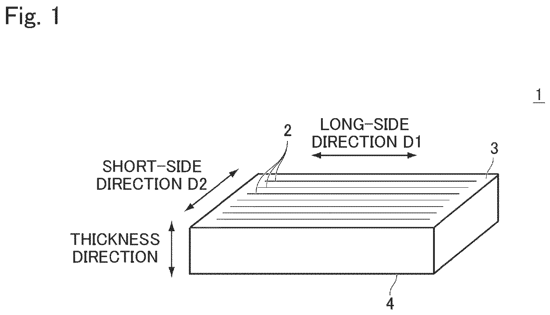

The following first describes the magnetostrictive member of the present embodiment. Fig. 1 is a diagram of an example of the magnetostrictive member according to the embodiment.

As illustrated in Fig. 1, this magnetostrictive member 1 is a plate-shaped body having a long-side direction D1 and a short-side direction D2. The plate-shaped body is preferably a rectangular shape in a plan view. The plate-shaped body has a front surface 3 and a back surface 4. The front surface 3 and the back surface 4 are preferably parallel to each other but are not necessarily parallel to each other.

The magnetostrictive member 1 is formed of a crystal of an iron-based alloy. A plurality of magnetostrictive members 1 are obtained from the same crystal. The iron-based alloy is not limited to a particular alloy so long as it has magnetostrictive characteristics. The magnetostrictive characteristics mean characteristics causing a shape change when a magnetic field is applied. The iron-based alloy is, for example, an alloy such as Fe-Ga, Fe-Ni, Fe-Al, Fe-Co, Tb-Fe, Tb-Dy-Fe, Sm-Fe, or Pd-Fe. The iron-based alloy may be any of the above-mentioned alloys with a third component added. The iron-based alloy may be, for example, an Fe-Ga alloy with Ba, Cu, or the like added. Among these iron-based alloys, the Fe-Ga alloy has larger magnetostrictive characteristics and is easier to process than other alloys and thus has been applied to materials for vibration power generation in the energy harvesting field, wearable terminals, sensors, and the like. In the following description, an example of a configuration in which the magnetostrictive member 1 is formed of a single crystal of the Fe-Ga alloy will be described as an example of the magnetostrictive member 1.

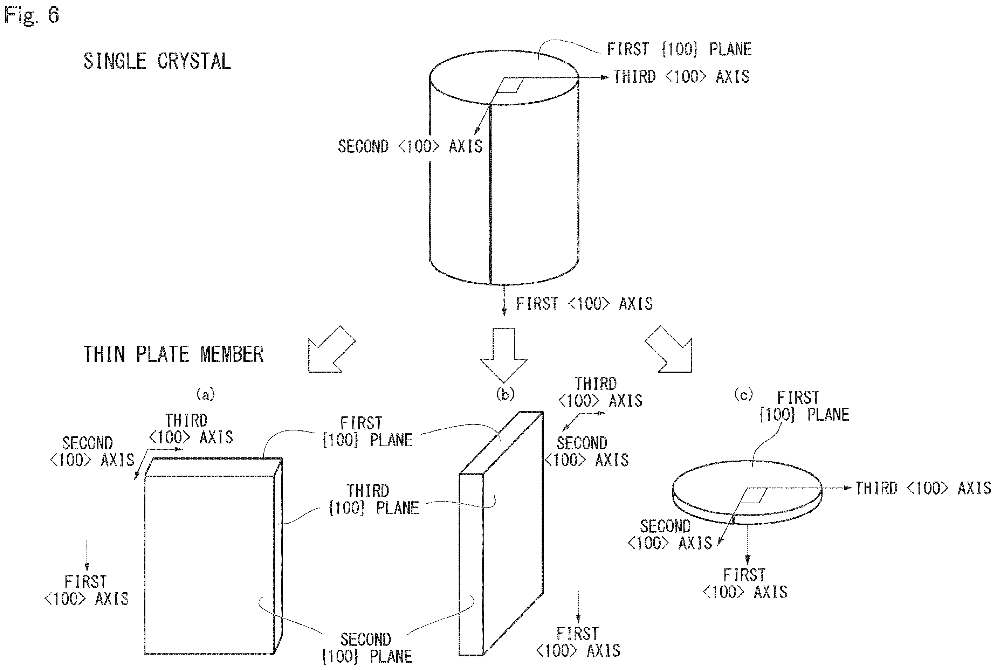

The single crystal of the Fe-Ga alloy has a body-centered cubic lattice structure and is based on the fact that first to third <100> axes (see Fig. 6) of the directional indices in the Miller indices are equivalent and first to third {100} planes (see Fig. 6) of the plane indices in the Miller indices are equivalent (i.e., (100),

(010), and (001) are equivalent). In addition, the Fe-Ga alloy has the characteristic of exhibiting large magnetic distortion in a specific orientation of the crystal. When this characteristic is used for a magnetostrictive vibration power generation device, it is desirable to match the direction in which the magnetostriction of the magnetostrictive member 1 is required in the device and the orientation (direction) in which the magnetic strain of the crystal is maximum with each other. Specifically, as described above, it is desirable to set the <100> direction, which is the easy direction of magnetization in the single crystal, to the long-side direction D1 of the magnetostrictive member 1. Setting the <100> direction, which is the easy direction of magnetization in the single crystal, to the long-side direction D1 of the magnetostrictive member 1 can be performed, for example, by calculating the crystal orientation of the single crystal by known crystal orientation analysis and cutting the single crystal on the basis of the calculated crystal orientation of the single crystal.

The crystal that can be used for the magnetostrictive member 1 of the present embodiment may be a single crystal or a polycrystal. The use of the single crystal is more advantageous than the polycrystal in order to increase the orientation integration in the <100> direction and to enhance characteristics as a magnetostrictive material. The polycrystal can be produced at low cost, although its magnetostrictive characteristics are lower than those of the single crystal, and thus the polycrystal may be used in some cases.

The magnetostrictive member 1 is used, for example, as materials (components) for vibration power generation devices in the energy harvesting field and materials (components) for wearable terminals, sensors, and the like. For example, the magnetostrictive vibration power generation device as disclosed in Patent Literature 5 above includes a coil, an Fe-Ga alloy magnetostrictive member wound on the coil, a yoke, and a field permanent magnet. This magnetostrictive vibration power generation device has a mechanism in which, when the yoke as a movable part of the device is vibrated, the magnetostrictive member fixed at the central part of the yoke vibrates in tandem, the magnetic flux density of the coil wound on the magnetostrictive member changes due to the inverse magnetostriction effect, and electromagnetic induction electromotive force is generated to generate power. When used on such a mechanism, it is preferable that the shape of the magnetostrictive member 1 is like a thin plate and is set to an elongated rectangular shape in a plan view. The thickness of the magnetostrictive member 1 is not limited to a particular thickness. For example, the thickness is preferably 0.3 mm to 5 mm. The shape and the size of the magnetostrictive member 1 are set as appropriate in accordance with the size of an objective device. For example, the magnetostrictive member 1 may have a length of one side of 5 mm or more, 10 mm or more, or 30 mm or more. For example, the size of the magnetostrictive member 1 may include a length (dimension) in the long-side direction D1 of 16 mm, a width (dimension) in the short-side direction D2 of 4 mm, and a thickness of 0.5 mm.

The shape and the dimensions of the magnetostrictive member 1 are not limited to particular ones. For example, the magnetostrictive member 1 need not have a rectangular shape in a plan view. For example, the shape of the magnetostrictive member 1 may be elliptic, track-shaped, or irregular in a plan view. When the shape of the magnetostrictive member 1 is other than the rectangular shape in a plan view, the long-side direction D1 is a long-diameter direction, a long-axis direction, or the like, whereas the short-side direction D2 is a direction orthogonal to the long-side direction D1.

As described above, the inventors of the present invention have confirmed that by adding a plurality of grooves, for example, grinding marks, extending in the long-side direction of the magnetostrictive member as in Patent Literature 6, a magnetostrictive member with a high magnetostriction constant and a high parallel magnetostriction amount and a small variation in the magnetostriction constant and the parallel magnetostriction amount among members can be obtained, but have found that a magnetostrictive vibration power generation device including this magnetostrictive member involves a large variation in the optimum magnetic field strength of the magnetostrictive member and thus requires adjustment of the magnet strength according to the variation in the optimum magnetic field strength for each device, which reduces productivity. To address this, the inventors of the present invention have found that the variation in the optimum magnetic field strength can be reduced by performing heat treatment on the magnetostrictive member. The inventors of the present invention have also founded that it is useful to evaluate the characteristics of a heat-treated magnetostrictive member using electromechanical equivalent circuit analysis. The present invention has been made on the basis of the above findings.

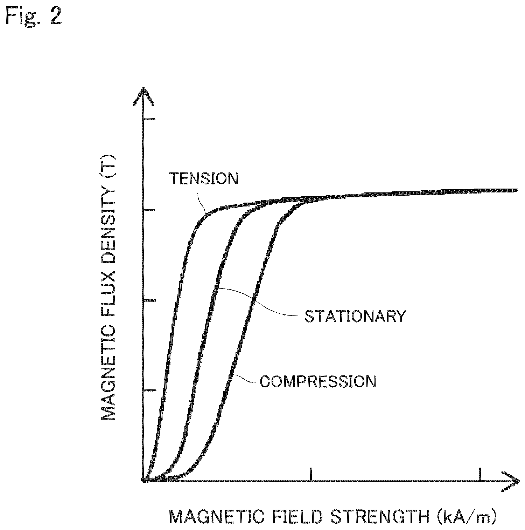

Since the magnetostrictive member is used in the magnetostrictive vibration power generation device, the principle of magnetostrictive vibration power generation will be first described. The axis of easy magnetization of iron-based magnetostrictive materials is [100]. As illustrated in Fig. 2, applied magnetic field strength required for magnetic field saturation increases with compressive stress applied in the [100] direction, whereas the applied magnetic field strength required for magnetic field saturation decreases with tensile stress applied in the [100] direction. When a bias magnetic field is applied to the magnetostrictive material to continuously generate the compressive stress and the tensile stress, magnetic flux density in the difference of a B-H curve changes. Magnetostrictive vibration power generation uses this change in the magnetic flux density to generate an alternating current in a coil covering the magnetostrictive material through Faraday's electromagnetic induction.

In Fig. 2, when there is no magnetic field (magnetic field strength is 0 kA/m), the magnetic flux density is also near 0 T both under compression and tension, and the magnetic flux density does not change and no power is generated. As the magnetic field strength increases, a difference occurs between the magnetic flux density under compression and the magnetic flux density under tension, and power can be generated. When the magnetic field strength becomes very large, the magnetic field saturates both under compression and tension, and thus little difference in the magnetic field strength occurs, and no power is generated. Therefore, for efficient power generation, the magnetic field strength is required to be optimized and applied so that the difference in the magnetic flux density between under compression and under tension is maximized. The magnetic field strength at this time is referred to as the optimum magnetic field strength in the present specification.

A method for evaluating power generation characteristics in magnetostrictive vibration power generation devices is a method of evaluation by analysis with an electromechanical equivalent circuit (impedance measurement), as disclosed in Patent Literature 7 and Non-Patent Literature 5 above.

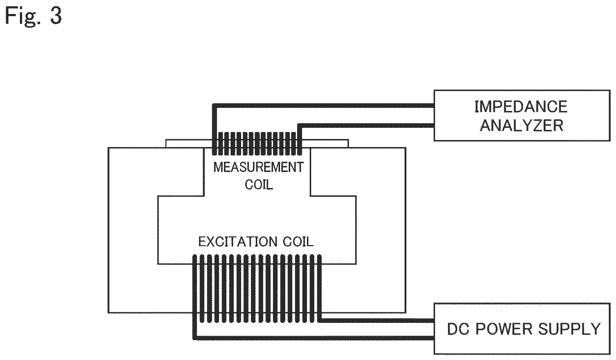

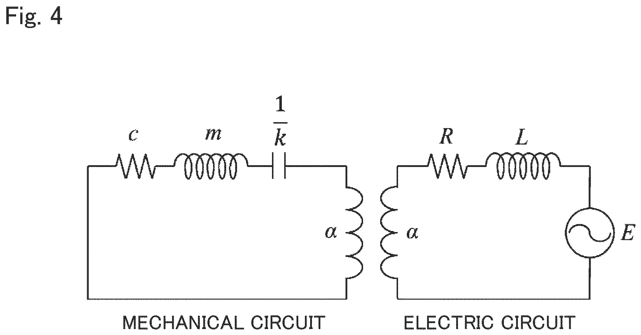

The analysis with an electromechanical equivalent circuit (impedance measurement) will be described below. Fig. 3 illustrates an overview of an impedance measurement apparatus. A bias magnetic field is generated with a direct current (DC) power supply by an excitation coil to magnetize a magnetostrictive material. With the magnetostrictive material put in the measurement coil, the impedance of the measurement coil is measured. Fig. 4 illustrates an equivalent circuit of the measurement coil, and the equivalent impedance of this circuit can be represented by Expression (1) below. The force coefficient $\alpha$ is the degree of coupling between a mechanical system and an electric system, serves as an indicator of energy conversion efficiency from mechanical energy to electric energy, and is positively correlated with the power generation output of a vibration power generation device.

[Math. 1]

$$Z = Z_E + \frac{\alpha^2}{Z_M} = R + j\omega L + \frac{\alpha^2}{c + j\omega m + \frac{k}{j\omega}}$$

(Expression 1)

R: Winding resistance of coil ($\Omega$)
L: Inductance (H)
k: Spring constant (N/m)
m: Equivalent mass (kg)

c: Viscous damping coefficient (Ns/m)
$\alpha$: Force coefficient (N/A)

A component obtained by removing an electric circuit component is excluded from the measured impedance loop to convert it to a dynamic impedance loop, and the force coefficient $\alpha$ is calculated from Expression (2) and Expression (3) below.
[Math. 2]

$$c = 2\pi m(f_2 - f_1) \qquad \text{(Expression 2)}$$

$f_1$: Frequency giving argument + 45°
$f_2$: Frequency giving argument - 45°
[Math. 3]

$$\alpha = \sqrt{c \cdot R_m} \qquad \text{(Expression 3)}$$

$R_m$: Diameter of dynamic impedance loop

The above-described impedance measurement is performed a plurality of times while changing the bias magnetic field generated by the excitation coil by changing the current of the DC power supply. When the force coefficient $\alpha$ is measured while the magnetic field strength is changed from 0 kA/m to a saturation magnetic field, the force coefficient $\alpha$ is maximized around half of the saturation magnetic field strength, and otherwise the force coefficient $\alpha$ decreases. The magnetic field strength at which the force coefficient $\alpha$ is maximized is the optimum magnetic field strength. The force coefficient $\alpha$ at the optimum magnetic field strength is denoted as a force coefficient $\alpha$max (note that the force coefficient $\alpha$max may be abbreviated as the force coefficient). That is, the bias magnetic field is generated to magnetize the magnetostrictive material, and with the magnetostrictive material put in the coil for measurement, the impedance of the coil for measurement is measured a plurality of times with the bias magnetic field changed up to the saturation magnetic field strength, and based on an obtained measurement result of the impedance of the coil for measurement, the characteristics of the magnetostrictive member including the optimum magnetic field strength, which is magnetic field strength at which the force coefficient $\alpha$ is maximized, and the force coefficient $\alpha$max at the optimum magnetic field strength can be determined.

The power generation characteristics of a magnetostrictive material can be evaluated by the force coefficient $\alpha$max, but if the magnetic field strength deviates from the optimum magnetic field strength, the power generation characteristics will decrease. That is, since the force coefficient $\alpha$ depends on the applied magnetic field strength, it is ideal to design a bias magnet such that the force coefficient $\alpha$max is available in the power generation device and the magnetic field strength is the optimum magnetic field strength. Therefore, the optimum magnetic field strength is also an important characteristic index and is required not to vary from one magnetostrictive material to another. A smaller optimum magnetic field strength is preferable from the viewpoint of downsizing the power generation device, since the bias magnet to be incorporated into the power generation device can be made smaller.

In the magnetostrictive member of the present embodiment, the optimum magnetic field strength and the force coefficient $\alpha$max at the optimum magnetic field strength determined by the analysis by the above-described method with the electromechanical equivalent circuit are used as indicators as the characteristics of the magnetostrictive member. The force coefficient $\alpha$max and the optimum magnetic field strength at the time of impedance measurement with the impedance measurement apparatus device described above are used as indicators. This allows for a better correlation with the device's power generation amount because the impedance measurement allows for evaluation over a wide area within the coil, whereas the magnetostriction measurement allows for evaluation over a narrow area to which a strain gauge is attached. Furthermore, by making the measurement coil shape of the impedance jig similar to that of the device and making the position of the magnetostrictive material inserted into the measurement coil equivalent to that of the device, the correlation with the device's power generation amount becomes even better. In addition, the characteristics of the magnetostrictive member including the force coefficient and the optimum magnetic field strength can be evaluated with high accuracy. In addition, the impedance measurement makes it possible to easily predict the selection of a magnet for the magnetostrictive vibration power generation device and the output from the magnetostrictive vibration power generation device when the magnetostrictive member is used in the magnetostrictive vibration power generation device.

The magnetostrictive member of the present embodiment is a magnetostrictive member being formed of a crystal of an iron-based alloy having magnetostrictive characteristics, being a plate-shaped body having a long-side direction and a short-side direction, and having a plurality of grooves extending in the long-side direction on at least one surface of a front surface and a back surface of the plate-shaped body, the magnetostrictive member having a ratio (standard deviation/average value) of a standard deviation of optimum magnetic field strength to an average value of the optimum magnetic field strength of 0.2 or less, and the optimum magnetic field strength being calculated by electromechanical equivalent circuit analysis. The following gives a detailed description.

As illustrated in Fig. 1, at least one surface of the front surface 3 and the back surface 4 (may be collectively referred to as the "front and back surfaces") of the magnetostrictive member 1 of the present embodiment has a plurality of grooves 2 extending in the long-side direction D1. For the grooves 2 extending in the long-side direction D1, for example, the same as those in Patent Literature 6 above can be employed. As illustrated in Patent Literature 6 above, by forming the grooves 2 extending in the long-side direction D1 on at least one surface of the front and back surfaces of the magnetostrictive member, both the magnetostriction constant and the parallel magnetostriction amount can be modified (also referred to as the "modification of the magnetostriction constant and the parallel magnetostriction amount") so as to be at a high level and have a small variation among members, and in particular, the parallel magnetostriction amount can be modified. In the present embodiment, the grooves 2 extending in the long-side direction D1 include the grooves 2 extending in a direction parallel to the long-side direction D1 and the grooves 2 extending in a direction intersecting the long-side direction D1 at an angle of less than 40°.

As illustrated in Patent Literature 6 as described above, it has been found that the magnetostriction constant and the parallel magnetostriction amount are stable at a high level by forming the grooves 2 on the surface of the magnetostrictive member. It has been found that the force coefficient is stable at a high level when the impedance measurement described above is made using this magnetostrictive member. For example, as illustrated in examples described below, in Comparative Examples 1 and 2, the surface of the magnetostrictive members is a wire-machined surface (a surface obtained by slicing a single crystal ingot with a wire saw), in which the grooves 2 are not formed, whereas Examples 1 to 3 are magnetostrictive members in which the grooves 2 are formed on the surface of the magnetostrictive members. It can be seen that in the magnetostrictive members of these examples and comparative examples, the force coefficient has a high average value and a small variation, and is stable at a high level in Examples 1 to 4 (before heat treatment). In contrast, in Comparative Examples 1 and 2 (before heat treatment), the force coefficient has a lower average value, a larger variation, and less stability. This is assumed to be caused by the fact that by forming the grooves on the surface of the magnetostrictive member, stress such as residual strain is applied in the crystal predominantly in a direction orthogonal to the grooves by the Twyman effect, and the magnetic moment is uniformly rearranged to make the magnetostrictive characteristics uniform.

However, the optimum magnetic field strength is found to have a variation in Examples 1 to 4 (before heat treatment). If the optimum magnetic field strength has a variation due to the magnetostrictive member, as described above, devices for use in magnetostrictive vibration power generation and the like require the adjustment of the magnet strength for each device, causing a decrease in productivity. Given these circumstances, the present invention is characterized by reducing a variation in the optimum magnetic field strength by performing heat treatment with the grooves 2 formed on the surface of the magnetostrictive member. Details will be described below.

In Examples 1 to 4, the variation (standard deviation ($\sigma$)) in the optimum magnetic field strength after heat treatment is smaller than that before heat treatment. The ratio ($\sigma$ after heat treatment/$\sigma$ before heat treatment) of the variation (standard deviation ($\sigma$)) of the optimum magnetic field strength after heat treatment to that before heat treatment is less than 1.0, preferably 0.8 or less, and more preferably 0.5 or less. The heat treatment has the effect of relieving the internal stress of the magnetostrictive member. By forming the grooves 2 on the surface of the magnetostrictive member, stress such as residual strain is applied in the crystal in a certain direction, and the magnetic moment is uniformly rearranged to make the parallel magnetostriction amount and the force coefficient at a high level, but there are differences in internal stress due to crystal growth for each magnetostrictive member manufactured, which is considered to cause the increased variation in the optimum magnetic field strength. In the magnetostrictive member 1 of the present embodiment, it is considered that by performing the heat treatment after forming the grooves 2 on the surface of the magnetostrictive member 1, the internal stress is relieved and made uniform following the stress such as residual strain in a certain direction, and thus a magnetostrictive member with a parallel magnetostriction amount and a force coefficient that are stable at a high level and with a small variation in the optimum magnetic field strength can be obtained.

Note that in the present embodiment, the magnitudes of the optimum magnetic field strength and the force coefficient are affected by the width, length, and thickness of the magnetostrictive member due to a demagnetizing field. Given this, in the present embodiment, evaluation was performed based on a ratio (σ/AVE) of the variation (standard deviation ($\sigma$)) to an average value (AVE) of the optimum magnetic field strength. This evaluation enables reduction in the influence of the width, length, and thickness of the magnetostrictive member on the optimum magnetic field strength.

In the magnetostrictive members before heat treatment in Examples 1 to 4, the ratio (σ/AVE) of the variation (standard deviation ($\sigma$)) to the average value of the optimum magnetic field strength exceeds 0.2, whereas after heat treatment, the ratio (σ/AVE) of the variation (standard deviation ($\sigma$)) to the average value of the optimum magnetic field strength is 0.2 or less, preferably 0.18 or less, and more preferably 0.16 or less. Note that the lower limit thereof may be, for example, 0.01 or more. Although the average value of the optimum magnetic field strength of the magnetostrictive member varies depending on the width, length, and plate thickness of the magnetostrictive member, the ratio (o/AVE) of the variation to the average value of the optimum magnetic field strength is reduced to 0.2 or less by the heat treatment, indicating that the variation in the optimum magnetic field strength is significantly reduced. In the magnetostrictive members in Examples 1 to 3, it can be seen that the heat treatment can reduce the optimum magnetic field strength (the average value) from that before heat treatment. When the optimum magnetic field strength of the magnetostrictive member (magnetostrictive material) is high, a magnet with a strong magnetic flux density is required. With the magnetostrictive members in Examples 1 to 3, the optimum magnetic field strength (the average value) is reduced from that before heat treatment, and thus the magnetic flux density of the magnet used can be reduced. For example, in the magnetostrictive member of the present embodiment, the ratio (after heat treatment/before heat treatment) of the optimum magnetic field strength (average value) after heat treatment to that before heat treatment is 1.0 or less, and preferably 0.8 or less. In the magnetostrictive member 1 of the present embodiment, the average value of the optimum magnetic field strength (kA/m) (after heat treatment) is, for example, 1.0 or more, preferably 1.6 or more, and more preferably 2.0 or more.

The force coefficient does not change before and after heat treatment and is stable at a high level. In the magnetostrictive member 1 of the present embodiment, the ratio of the variation (standard deviation) to the average value of the force coefficient (N/A) is 0.3 or less, and preferably 0.1 or less. Note that the lower limit thereof may be, for example, 0.001 or more. In the magnetostrictive member 1 of the present embodiment, the force coefficient (N/A) is, for example, 100 or more, preferably 140 or more, and more preferably 150 or more. Note that in the present embodiment, the force coefficient and the optimum magnetic field strength are values calculated by the electromechanical equivalent circuit analysis as described above, and can be obtained by, for example, the methods described in the present specification.

As in Examples 1 to 4, the magnetostrictive member 1 of the present embodiment may have a ratio (standard deviation/average value) of the variation (standard deviation) of the optimum magnetic field strength to the average value of the optimum magnetic field strength of 0.2 or less, and have a ratio (variation/average value) of the variation (standard deviation) of the force coefficient to the average value of the force coefficient of the magnetostrictive member of 0.3 or less. Note that the lower limit thereof may be, for example, 0.01 or more.

Note that each average value and variation (standard deviation) may be values calculated from a plurality of magnetostrictive members produced from the same crystal. For example, they may be calculated from a plurality of magnetostrictive members produced under the same manufacturing conditions from one grown crystal, or produced simultaneously under the same manufacturing conditions. There is no limitation on the number of measurements (n-number) with respect to the number of magnetostrictive members produced from the same crystal and the calculation of each average value and variation (standard deviation). The n-number is preferably 4 to 10.

As described above, the magnetostrictive member of the present embodiment is a magnetostrictive member including a plurality of magnetostrictive members obtained from the same crystal, the magnetostrictive member being formed of a crystal of an iron-based alloy having magnetostrictive characteristics, being a plate-shaped body having a long-side direction and a short-side direction, and having a plurality of grooves extending in the long-side direction on at least one surface of a front surface and a back surface of the plate-shaped body, and the magnetostrictive members having a ratio (standard deviation/average value) of a standard deviation of optimum magnetic field strength to an average value of the optimum magnetic field strength determined by electromechanical equivalent circuit analysis of 0.2 or less. Owing to the above-described configuration, the magnetostrictive member of the present embodiment provides large device output and can reduce a variation in optimum magnetic field strength in device characteristics when a magnetostrictive vibration power generation device is manufactured using the magnetostrictive member with a high parallel magnetostriction amount and a small variation in the parallel magnetostriction amount among members. Note that from the viewpoint of reducing the variation in the optimum magnetic field strength, the magnetostrictive members are preferably obtained under the same manufacturing conditions, and more preferably obtained at once under the same manufacturing conditions.

(Method for Manufacturing Magnetostrictive Member)

The following describes a method for manufacturing a magnetostrictive member of the present embodiment. The method for manufacturing a magnetostrictive member of the present embodiment is a method for manufacturing the magnetostrictive member 1 of the present embodiment described above. The method for manufacturing a magnetostrictive member of the present embodiment is a method for manufacturing the magnetostrictive member 1 of the present embodiment, and includes: forming the grooves 2 extending in the long-side direction D1 on at least one surface of the front surface 3 and the back surface 4 of the plate-shaped body formed of a crystal of an iron-based alloy having magnetostrictive characteristics and having the long-side direction D1 and the short-side direction D2; and performing heat treatment on the plate-shaped body provided with the grooves extending in the long-side direction.

In the following description, a method for manufacturing the magnetostrictive member 1 from a single crystal ingot of an Fe-Ga alloy will be described as an example, but the method for manufacturing a magnetostrictive member of the present embodiment is not limited to the following description. It is assumed that any description herein that is applicable to the method for manufacturing a magnetostrictive member of the present embodiment is also applicable to the method for manufacturing a magnetostrictive member of the present embodiment. It is assumed that any in the method for manufacturing a magnetostrictive member of the present embodiment below that is applicable to the above-described magnetostrictive member of the present embodiment is also applicable to the magnetostrictive member of the present embodiment.

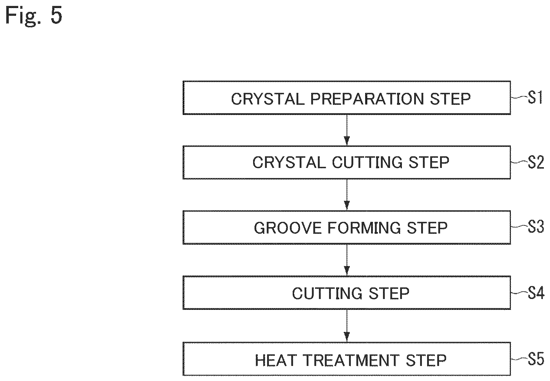

Fig. 5 is a flowchart of an example of the method for manufacturing a magnetostrictive member of the present embodiment. Fig. 6 is a diagram of first to third examples (a, b, c) of a single crystal (a single crystal ingot) and a thin plate member. The method for manufacturing a magnetostrictive member of the present embodiment includes, for example, a crystal preparation step (Step S1), a crystal cutting step (Step S2), a groove forming step (Step S3), a cutting step (Step S4), and a heat treatment step (Step S5).

In the method for manufacturing a magnetostrictive member of the present embodiment, first, in the crystal preparation step (Step S1), a crystal of an iron-based alloy having magnetostrictive characteristics is prepared. The crystal to be prepared may be a single crystal or a polycrystal. The crystal to be prepared may be a grown one or a commercially available one. For example, in the crystal preparation step, a single crystal of an Fe-Ga alloy is prepared. The method for growing the single crystal of the Fe-Ga alloy is not limited to a particular method. The method for growing the single crystal of the Fe-Ga alloy may be, for example, the pull-up method or the unidirectional solidification method. For example, the Cz method can be used as the pull-up method, and the VB method, the VGF method, the micro pull-down method, and the like can be used as the unidirectional solidification method.

For the single crystal of the Fe-Ga alloy, the magnetostriction constant is maximized by setting the content of gallium to 18.5 at% or 27.5 at%. For this reason, the Fe-Ga single crystal is grown so as to have the content of gallium of preferably 16.0 to 20.0 at% or 25.0 to 29.0 at% and more preferably 17.0 to 19.0 at% or 26.0 to 28.0 at%. The shape of the grown single crystal is not limited to a particular shape and may be cylindrical or quadrangular prismatic, for example. The grown single crystal may be made into a cylindrical single crystal by cutting a seed crystal, a diameter-increased part or a shoulder part (a part with an increased diameter from the seed crystal to a predetermined single crystal), or the like with a cutting apparatus, if necessary. The size of the single crystal to be grown is not limited to a particular size so long as it is large enough to ensure the magnetostrictive member in a predetermined direction. When the Fe-Ga single crystal is grown, it is grown using a seed crystal processed with the upper surface or the lower surface of the seed crystal to be the {100} plane so that the growth axis direction is <100>. In the Fe-Ga alloy single crystal to be grown, the crystal is grown in a direction perpendicular to the upper surface or the lower surface of the seed crystal, and the orientation of the seed crystal is inherited.

Following the crystal preparation step (Step S1), the crystal cutting step (Step S2) is performed. The crystal cutting step is a step for cutting the crystal to produce a thin plate member. The thin plate member is a member to be the material of the magnetostrictive member 1 of the present embodiment. The crystal cutting step is, for example, a step for cutting the single crystal of the Fe-Ga alloy having magnetostrictive characteristics using a cutting apparatus to produce a thin plate member with the {100} plane as its principal plane. As the cutting apparatus, a cutting apparatus such as a wire electric discharge machine, an inner peripheral blade cutting apparatus, or a wire saw can be used. Among these, the use of a multi-wire saw is particularly preferable because it can cut a plurality of thin plate members at the same time. The cutting direction of the single crystal in the case of the Fe-Ga single crystal is <100>, and cutting is performed such that a cut plane, that is, the principal plane of the thin plate member is the {100} plane. The cutting direction of the single crystal is not limited to a particular direction. The cutting direction of the single crystal may be a perpendicular direction or a parallel direction with respect to the growing direction of the single crystal (the direction in which the crystal is grown) as illustrated in Fig. 6, for example.

Following the crystal cutting step (Step S2), the groove forming step (Step S3) is performed. The groove forming step forms the grooves 2 on at least one surface of the front surface 3 and the back surface 4 of the obtained thin plate member. In the groove forming step, a material of a magnetostrictive member having magnetostrictive characteristics such as the force coefficient of the present embodiment can be obtained by adjusting the configuration of the grooves 2 formed in the magnetostrictive member as appropriate. The grooves 2 can stabilize the magnetostriction constant, the parallel magnetostriction amount, and the force coefficient at a high level and modify magnetostrictive characteristics such as the magnetostriction constant, the parallel magnetostriction amount, and the force coefficient. In the groove forming step, the grooves 2 are formed in the thin plate member such that when the thin plate member is finally cut and made into the magnetostrictive member 1, the grooves 2 extending in the long-side direction D1 of the magnetostrictive member 1 are formed. For example, the grooves 2 can be formed by performing surface grinding on at least one surface of the front and back surfaces of the thin plate member obtained by the crystal cutting step. The following describes an example in which the groove forming step is performed by the surface grinding on the thin plate member. When the grooves 2 are formed by the surface grinding, the effect of the modification of magnetostrictive characteristics such as the magnetostriction constant, the parallel magnetostriction amount, and the force coefficient described above can be efficiently expressed. That is, in the magnetostrictive member 1 of the present embodiment, at least one surface of the front surface and the back surface of the plate-shaped body preferably includes a unidirectional machined surface in which the long-side direction is a machining direction.

The surface grinding is performed using a surface grinder. From the viewpoint of efficiently expressing the effect of the modification of the magnetostriction constant and the parallel magnetostriction amount, the surface grinding is preferably performed such that the direction of the grinding marks formed on the thin plate member is a direction parallel to the long-side direction D1 of the magnetostrictive member 1. For this reason, the grinding marks are preferably straight. To make the grinding marks straight, the surface grinder is preferably of a type in which the moving direction of a grinding wheel or a processing table is straight, and the surface grinder of a type including a flat grinding wheel and in which the processing table reciprocates is preferably used. The surface grinder including a cup grinding wheel and in which the processing table rotates can also be used, but when using such a surface grinder, the grinding marks are curved, and thus it is preferable to set the curvature of the grinding marks to be small (less curved).

The grinding marks are required to be formed on the surface of the magnetostrictive member 1. For this reason, when processing is performed by thickness adjustment or the like of the thin plate member, the surface grinding may be performed after predetermined processing is performed with a processing machine other than the surface grinder such as a double-sided lapping apparatus or a surface grinder including a cup grinding wheel or the like. The surface of the thin plate member (the magnetostrictive member) may be finished to be a mirror surface by performing polishing as in a conventional manner, followed by the surface grinding. From the viewpoint of efficiently expressing the effect of the modification of the magnetostriction constant and the parallel magnetostriction amount, the surface grinding is preferably performed on both the front and back surfaces of the thin plate member.

The grinding wheel used for the surface grinding has a lower limit of the roughness (grit) of the grinding wheel of preferably #40 or more and more preferably #100 or more, has an upper limit of preferably #500 or less and more preferably #400 or less, and has a range of preferably #40 or more and #500 or less, more preferably #40 or more and #400 or less, and more preferably #100 or more and #400 or less, for example. When the roughness (grit) of the grinding wheel is in any of the above ranges, the effect of the modification of the magnetostriction constant and the parallel magnetostriction amount can be more reliably demonstrated. Note that if a grinding wheel smaller than #40 is used, the size of the grinding marks is not necessarily stabilized. If a grinding wheel exceeding #500 is used, the surface of the magnetostrictive member may become smooth, and the effect of the modification of the magnetostriction constant and the parallel magnetostriction amount may not be efficiently expressed.

In the groove forming step, for example, the grooves 2 are preferably formed in the magnetostrictive member 1 such that the surface roughness Ra of the surface in which the grooves 2 are formed in the long-side direction D1 is in a certain range. For example, the grooves 2 are preferably formed such that the surface roughness Ra of the surface in which the grooves 2 are formed in the long-side direction D1 has a lower limit of preferably 0.3 $\mu$m or more, an upper limit of preferably 1.5 $\mu$m or less, and a range of 0.3 $\mu$m or more and 1.5 $\mu$m or less. The grooves 2 are preferably formed in the magnetostrictive member 1 such that the surface roughness Ra of the surface in which the grooves 2 are formed in the short-side direction D2 has a lower limit of preferably 0.6 $\mu$m or more and more preferably 0.7 $\mu$m or more, a lower limit of preferably 4.5 $\mu$m or less, and a range of preferably 0.6 $\mu$m or more and 4.5 $\mu$m or less. The grooves 2 are preferably formed in the magnetostrictive member 1 or a magnetostrictive material serving as the material of the magnetostrictive member 1 such that the magnetostriction constant and the parallel magnetostriction amount are in certain ranges. For example, the grooves 2 are preferably formed in the magnetostrictive member 1 or the magnetostrictive material such that the magnetostriction constant is 200 ppm or more and the parallel magnetostriction amount is 200 ppm or more. The grooves 2 with the surface roughness Ra, the magnetostriction constant, and the parallel magnetostriction amount in the preferable ranges described above can be formed by the surface grinding described above. The groove forming step may be performed by a method other than the surface grinding if it can form the grooves 2 on at least one surface of the front surface 3 and the back surface 4 of the obtained thin plate member. For example, the thin plate member may be produced such that the grooves 2 are formed with a fixed abrasive grain wire saw. That is to say, the grooves 2 may be grooves formed when the crystal is sliced with the fixed abrasive grain wire saw to produce the thin plate member. The cutting with the wire saw is classified into the free abrasive grain type in which a workpiece is pressed against a plurality of ultrathin wire rows parallel to each other at a fixed pitch, and while the wire is fed in a line direction, the workpiece is cut by supplying a processing liquid (also referred to as slurry) containing abrasive grains between the workpiece and the wire, and the fixed abrasive grain type in which a workpiece is cut while a wire on which abrasive grains such as diamond are fixed with electrodeposition or an adhesive is fed in a line direction. The cut surface in the free abrasive grain type is a pearskin surface having no directivity, and the effect of the present invention is not obtained. In contrast, when cutting is performed with the fixed abrasive grain wire saw, grinding marks are generated in the wire feeding direction, and the grooves 2 similar to those by the surface grinding can be formed. When cutting is performed with the fixed abrasive grain wire saw, the crystal cutting step (Step S2) and the groove forming step (step S3) can be shared, and thus the thin plate member can be efficiently produced. The grooves 2 may be formed by applying a certain amount of pressure with sandpaper or the like. In the groove forming step, a material of a magnetostrictive member having the force coefficient and the like of the present embodiment can be obtained by adjusting the configuration of the grooves 2 formed in the magnetostrictive member as appropriate. For example, as described above, in the present embodiment, while the magnetostrictive characteristics including the optimum magnetic field strength and the force coefficient are affected by the width, length, and thickness of the magnetostrictive member, by adjusting the configuration of the grooves 2 formed in the magnetostrictive member as appropriate in accordance with the width, length, and thickness of the magnetostrictive member in the groove forming step, a magnetostrictive member with adjusted (modified) magnetostrictive characteristics and having the force coefficient and the like of the present embodiment can be obtained. The configuration (conditions) of the grooves 2 formed in the magnetostrictive member of the present embodiment can be set by a preliminary experiment.

Following the groove forming step (Step S3), the cutting step (Step S4) is performed. The cutting step is a step for cutting the thin plate member in which the grooves 2 are formed in the groove forming step to obtain a magnetostrictive material. This magnetostrictive material serves as the material of the magnetostrictive member 1 of the present embodiment. By performing heat treatment on this magnetostrictive material in the heat treatment step described below, the magnetostrictive member 1 of the present embodiment can be obtained.

In the cutting step, when the thin plate member in which the grooves 2 are formed is cut, the thin plate member is cut such that the grooves 2 extending in the long-side direction D1 are formed in the magnetostrictive member 1 to be finally manufactured. In the cutting step, the thin plate member is cut into a predetermined size. In the cutting step, the thin plate member is cut as the magnetostrictive material such that, for example, the magnetostrictive member 1 becomes a rectangular plate-shaped body in a plan view. In the cutting step, the thin plate member is cut using a cutting apparatus. The cutting apparatus used in the cutting step is not limited to a particular cutting apparatus. For example, an outer peripheral blade cutting apparatus, a wire electric discharge machine, a wire saw, or the like can be used. The direction in which the magnetostrictive material is extracted from the thin plate member, which is not limited to a particular direction, may be set to a direction allowing efficient acquisition depending on the size of the magnetostrictive member or the like, for example.

Finally, the heat treatment step (Step S5) is performed. In the heat treatment step, the material is heat-treated to further reduce the optimum magnetic field strength of the magnetostrictive member and reduce the variation while the force coefficient is maintained at a high level. It is assumed that this is because the heat treatment relieves the internal stress of the front and back surfaces of the magnetostrictive member. For example, in the heat treatment step, the grooves 2 extending in the long-side direction D1 are formed on the front and back surfaces of the magnetostrictive material obtained in the cutting step, and this magnetostrictive material is heat-treated at a certain temperature and time. This heat treatment modifies the ratio (standard deviation/average value) of the standard deviation of the optimum magnetic field strength to the average value of the optimum magnetic field strength determined by the electromechanical equivalent circuit analysis in the magnetostrictive member to be 0.2 or less. The heat treatment performs modification to achieve the ratio of the variation (standard deviation) to the average value of the force coefficient of 0.3 or less. The heat treatment modifies the average value of the optimum magnetic field strength and the average value of the force coefficient to be in the ranges described above. The magnetostrictive member 1 of the present embodiment can be obtained by this heat treatment. The effect of the heat treatment to further reduce the optimum field strength of the magnetostrictive member and reduce the variation while maintaining the force coefficient at a high level is also effective for materials that do not have the grooves 2.

The method of heat treatment is not limited to a particular method. For example, a box-shaped or tubular electric furnace or the like can be used. The heating temperature is not limited to a particular temperature so long as it is a temperature at which the effects of the heat treatment are exhibited. The conditions of the heat treatment (temperature and time) can be obtained by a preliminary experiment. The heating temperature of the heat treatment (heat treatment temperature) is, for example, preferably 400°C or higher and 700°C or lower, and more preferably 600°C or higher and 650°C or lower. If the heat treatment temperature is lower than 400°C, the temperature is too low, and thus the optimum magnetic field strength may not change because the internal stress is not relieved by the heat treatment. If the heat treatment temperature exceeds 700°C, the temperature is too high, and thus the heat treatment weakens the effect of grinding to lower the parallel magnetostriction amount, and the force coefficient also deceases accordingly. When the heat treatment temperature is within the above temperature range, the average value of the optimum magnetic field strength of the magnetostrictive member can be further reduced.

The retention time of the heat treatment is preferably 5 hours or less, more preferably 30 minutes or more and 5 hours or less, and more preferably 30 minutes or more and 1 hour. The above range can more surely exhibit the effect of reducing the variation in the magnetostrictive member.

The atmosphere during the heat treatment is preferably an inert gas atmosphere. For example, argon gas, nitrogen gas, or the like can be used. The use of the inert gas atmosphere prevents oxidation of the surface of the magnetostrictive member. Note that the inert gas may be continuously supplied to a heat treatment furnace. The flow depends on the heat treatment furnace, and is preferably 0.5 to 5 L/h when the inert gas is argon gas.

Note that if the heat treatment step (Step S5) is performed without performing the groove forming step (Step S3), the internal stress is relieved and the variation in the optimum magnetic field strength is reduced, but the force coefficient does not change, its average value is low, and its variation remains large.

Note that in the above example, after cutting to the shape of the magnetostrictive member in the cutting step (Step S4), the heat treatment step (Step S5) is performed, but in the present invention, the heat treatment step (Step S5) may be performed after the groove forming step (Step S3), and then the cutting step (Step S4) may be performed.

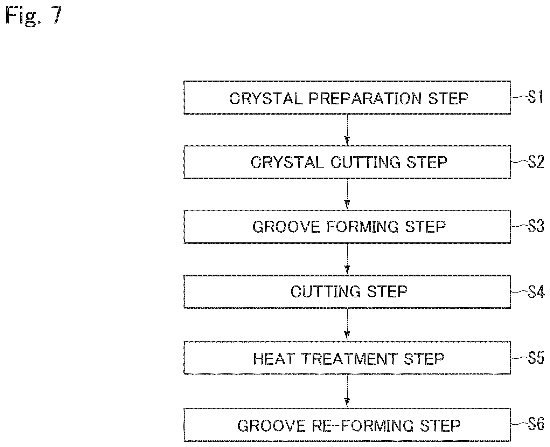

Furthermore, as illustrated in Fig. 7, after performing the heat treatment step (Step S5), a groove re-forming step (Step S6) of additionally re-forming the grooves 2 extending in the long-side direction on the heat-treated plate-shaped body may be performed. The groove re-forming step (Step S6) can be performed by, for example, forming grooves equivalent to those in the groove forming step (Step S3). The force coefficient is maintained by the groove re-forming step (Step S6). The average value of the optimum magnetic field strength may become larger, but the variation in the optimum field strength is maintained. Since the optimum magnetic field strength is preferably low, the groove re-forming step (Step S6) is preferably not performed, but it can be used for adjustment of the optimum magnetic field strength. Note that the groove 2 formed in the groove re-forming step (Step S6) may be formed under the same conditions as those in the groove forming step (Step S3) or may be formed under different conditions than those in the groove forming step (Step S3). That is, the grooves formed in the groove re-forming step (Step S6) may differ in configuration such as shape or amount from the grooves 2 formed in the groove forming step (Step S3).

[Examples]

The following specifically describes the present invention with reference to examples, but the present invention is not limited by these examples in any manner.

[Example 1]

A magnetostrictive member was manufactured on the basis of the method of manufacture of the present embodiment described above. With raw materials adjusted with a stoichiometric ratio of iron to gallium of 81:19, a cylindrical single crystal of an Fe-Ga alloy grown by the vertical Bridgman (VB) method was prepared (the crystal preparation step, Step S1). The growth axis direction of the single crystal was <100>. In the {100} plane of the upper surface or the lower surface of the single crystal perpendicular to the crystal growth axis direction, the orientation was confirmed by X-ray diffraction. In this process, upper surface and lower surface samples of the crystal were measured with a Shimadzu sequential plasma emission spectrometer (ICPS-8100), and the concentration of the single crystal had a content of gallium of 17.2 to 19.8 at%.

A magnetostrictive member was manufactured from the grown single crystal as follows. First, using a free abrasive grain wire saw apparatus, the single crystal was cut in a direction parallel to the single crystal growth direction (parallel to the <100> orientation) to produce a thin plate member with a cut plane, that is, a principal plane of {100} (the crystal cutting step, Step S2). Then, the obtained thin plate member was subjected to surface grinding with a surface grinder using a flat grinding wheel of #200 to adjust the thickness of the thin plate member, to adjust to obtain the magnetostrictive member of the present embodiment described above, and to form a plurality of grooves (grinding marks) on the front and back surfaces (the groove forming step, Step S3). Then, a cutting position was set such that the long-side direction of the magnetostrictive member was in the same direction as a grinding direction during the surface grinding, that is, a grinding mark direction, and a magnetostrictive material (a magnetostrictive member before heat treatment) with a size of a dimension in the long-side direction of 16 mm × a dimension in the short-side direction of 4 mm × a thickness of 0.5 mm was cut out with an outer peripheral blade cutting apparatus (the cutting step, Step S4).

Next, magnetostrictive characteristics were measured for the cut-out magnetostrictive material. In the measurement of the magnetostrictive characteristics, impedance measurement was performed using the impedance measurement apparatus illustrated in Fig. 4 described above to determine a force coefficient and optimum magnetic field strength. Note that the impedance measurement was performed as follows. A measurement coil was produced to exactly accommodate the cut-out 16 × 4 × 0.5 mm magnetostrictive member or magnetostrictive member, and impedance measurement equivalent to that in Patent Literature 7 was performed. With an excitation current ranged from 10 to 70 mA, a current was applied at 5 mA intervals. In terms of magnetic field strength, 1 mA = 78.4 A/m, and bias magnetic fields were applied at 0.392 kA/m intervals in the range of 0.784 to 5.488 kA/m. The impedance measurement was performed at a frequency of 50 to 150 kHz using an impedance analyzer, and the force coefficient $\alpha$ at each magnetic field strength was calculated. The optimum magnetic field strength at which the force coefficient $\alpha$ was maximized and the force coefficient $\alpha$max at that time were calculated.

Note that ten sheets of the above-described magnetostrictive material were produced, and the force coefficient and the optimum magnetic field strength were determined by the same method, and the average value and the variation (standard deviation) of each were calculated. Table 1 lists the results.

Next, the ten cut-out sheets of the magnetostrictive material described above were heat-treated. A tubular electric furnace was used as a heat treatment furnace. Argon gas was flowed into the furnace at 1 L/min. Heat treatment was performed on the conditions with a heat treatment temperature of 600°C and a retention time of 1 minute. Magnetostrictive members were obtained by the heat treatment (the heat treatment step, Step S5).

Subsequently, the force coefficient and the optimum magnetic field strength of the magnetostrictive members were measured. Table 1 lists the results. Note that Table 1 lists the average value (AVE) and the variation (standard deviation σ) of the ten magnetostrictive members. The ratio (standard deviation σ/average value AVE) of the variation (standard deviation σ) to the average value of the force coefficient and the optimum magnetic field strength, the average and the variation (standard deviation) of the optimum magnetic field strength, and the ratio (after heat treatment/before heat treatment) of those after heat treatment to those before heat treatment are calculated and listed in Table 1.

[Examples 2 and 3]

Examples 2 and 3 are comparisons in which the heating temperature of the heat treatment and the retention time of the heat treatment on the magnetostrictive member are changed.

In Example 2, the retention time of the heat treatment on the magnetostrictive member was set to 5 hours. The conditions other than the above were the same as in Example 1. In Example 3, the heating temperature of the heat treatment was set to 450°C. The conditions other than the above were the same as in Example 1. Table 1 lists their manufacturing conditions and evaluation results.

[Example 4]

In Example 4, Steps S1 to S5 were performed in the same manner as in Example 1 except the thickness was changed from 0.5 mm to 0.6 mm to produce a magnetostrictive material with a dimension in the long-side direction of 16 mm × a dimension in the short-side direction of 4 mm × a thickness of 0.6 mm, and then as the groove re-forming step (Step S6), surface grinding was performed with a surface grinder using a #200 flat grinding wheel to form a plurality of grooves (grinding marks) on the front and back surfaces. In the groove re-forming step (Step S6), the grooves (grinding marks) were made such that the long-side direction of the magnetostrictive member was the same direction as the grinding direction during the surface grinding, that is, the grinding mark direction. Table 1 lists the manufacturing conditions and the evaluation results. Note that the values after heat treatment in the table are values after the groove re-forming after the heat treatment.

[Comparative Examples 1 and 2]

In Comparative Example 1, the surface of the magnetostrictive material was a machined surface (wire saw-machined surface) cut by a free abrasive grain wire saw apparatus for cutting the surface by supplying a processing fluid containing abrasive grains. No grooves 2 are formed on the wire-machined surface. The conditions other than the above were the same as in Example 1. In Comparative Example 2, the retention time of the heat treatment on the magnetostrictive member was set to 5 hours. The conditions other than the above were the same as in Comparative Example 1. Table 1 lists the manufacturing conditions and the evaluation results.

[Example 5]

Example 5 is a comparison with Example 1 in which the size of the magnetostrictive member was changed and increased to a dimension in the long-side direction of 32 mm × a dimension in the short-side direction of 8 mm × a thickness of 1 mm, the grinding wheel was changed to a #80 flat grinding wheel to perform the surface grinding as the groove forming step (Step S3), and the retention time of the heat treatment on the magnetostrictive material was changed to 2 hours. Table 1 lists the manufacturing conditions and the evaluation results.

[Example 6]

Example 6 is a comparison with Example 1 in which the size of the magnetostrictive member was changed and increased to a dimension in the long-side direction of 64 mm × a dimension in the short-side direction of 16 mm × a thickness of 2 mm, the grinding wheel was changed to a #40 flat grinding wheel to perform the surface grinding as the groove forming step (Step S3), and the retention time of the heat treatment on the magnetostrictive material was changed to 2 hours. Table 1 lists the manufacturing conditions and the evaluation results.

[Example 7]

Example 7 is a comparison with Example 1 in which the size of the magnetostrictive member was changed and increased to a dimension in the long-side direction of 96 mm × a dimension in the short-side direction of 24 mm × a thickness of 3 mm, the grinding wheel was changed to a #40 flat grinding wheel to perform the surface grinding as the groove forming step (Step S3), and the retention time of the heat treatment on the magnetostrictive material was changed to 3 hours. Table 1 lists the manufacturing conditions and the evaluation results.

[Table 1]

| Size (mm) | Surface condition | Heat treatment temperature (°C) | Re-polishing step | Heat treatment time | Force coefficient (average) | | Force coefficient (variation, σ) | | Force coefficient ratio (σ/AVE) | | Optimum magnetic field strength (average) | | | Optimum magnetic field strength (variation σ) | | | Optimum magnetic field strength ratio (σ/AVE) | | |
|---|---|---|---|---|---|---|---|---|---|---|---|---|---|---|---|---|---|---|---|
| | | | | | Before heat treatment | After heat treatment | Before heat treatment | After heat treatment | Before | After | Before heat treatment | After heat treatment | Ratio (after heat treatment/before heat treatment) | Before heat treatment | After heat treatment | Ratio (after heat treatment/before heat treatment) | Before | After | Ratio (after heat treatment/before heat treatment) |
| Ex. 1 — 16 × 4 × 0.5 | #200 Ground surface | 600 | Absent | 1 hour | 178.0 | 175.8 | 3.8 | 4.1 | 0.02 | 0.02 | 2.94 | 1.78 | 0.61 | 0.81 | 0.21 | 0.26 | 0.28 | 0.12 | 0.43 |
| Ex. 2 | | 600 | | 5 hours | 178.6 | 174.7 | 4.0 | 2.0 | 0.02 | 0.01 | 2.78 | 1.69 | 0.61 | 0.91 | 0.26 | 0.29 | 0.33 | 0.15 | 0.47 |
| Ex. 3 | | 450 | | 1 hour | 188.0 | 190.0 | 5.2 | 2.2 | 0.03 | 0.01 | 3.21 | 2.16 | 0.67 | 0.90 | 0.21 | 0.23 | 0.28 | 0.10 | 0.35 |
| Ex. 4 | | 600 | #200 Grinding | 1 hour | 181.4 | 184.6 | 4.1 | 2.1 | 0.02 | 0.01 | 2.98 | 3.29 | 1.10 | 0.84 | 0.15 | 0.18 | 0.28 | 0.05 | 0.16 |
| Ex. 5 — 32 × 8 × 1 | #80 Ground surface | 600 | Absent | 2 hours | 319.2 | 318.1 | 8.9 | 5.4 | 0.03 | 0.02 | 4.00 | 2.25 | 0.56 | 1.22 | 0.16 | 0.13 | 0.31 | 0.07 | 0.23 |
| Ex. 6 — 64 × 16 × 2 | #40 Ground surface | 600 | | 2 hours | 844.0 | 884.7 | 23.4 | 11.1 | 0.03 | 0.01 | 2.27 | 1.39 | 0.61 | 0.59 | 0.11 | 0.19 | 0.26 | 0.08 | 0.30 |
| Ex. 7 — 96 × 24 × 3 | | 600 | | 3 hours | 980.1 | 1143.4 | 64.1 | 19.3 | 0.07 | 0.02 | 2.40 | 1.49 | 0.62 | 0.84 | 0.22 | 0.26 | 0.35 | 0.15 | 0.42 |
| Comp. Ex. 1 — 16 × 4 × 0.5 | Wire saw-machined surface | 600 | Absent | 1 hour | 134.4 | 128.4 | 65.4 | 79.0 | 0.49 | 0.61 | 1.57 | 1.72 | 1.10 | 0.37 | 0.33 | 0.89 | 0.24 | 0.19 | 0.81 |
| Comp. Ex. 2 | | 600 | | 5 hours | 134.7 | 127.6 | 63.2 | 72.8 | 0.47 | 0.57 | 1.53 | 1.57 | 1.03 | 0.29 | 0.41 | 1.41 | 0.19 | 0.26 | 1.38 |

[Conclusion]

From the results of the above examples, in Examples 1 to 3, the average value and the variation of the optimum magnetic field strength after heat treatment were smaller than those before heat treatment. In Example 4, the variation in the optimum magnetic field strength was smaller than that before heat treatment. The average value of the optimum magnetic field strength was larger than before heat treatment. In Examples 1 to 4, the ratio (σ after heat treatment/σ before heat treatment) of the variation of the optimum magnetic field strength after heat treatment to that before heat treatment was 0.3 or less, indicating that performing the heat treatment reduces the variation in the optimum magnetic field strength and makes it uniform. In Examples 1 to 4, the force coefficient did not change before and after heat treatment and favorably remained stable at a high level. In contrast to Examples 1 to 4, in Comparative Examples 1 and 2, the surface condition of the magnetostrictive member was a wire-machined surface, and the variation in the force coefficient was large, with no significant change before and after heat treatment. In Examples 1 to 6, the force coefficients before and after heat treatment were comparable, and the force coefficient was stable at a high level even without heat treatment. It was also found that the average value of the force coefficient was larger in Examples 5 to 7 than in Examples 1 to 4. Note that in Example 7, the force coefficient before heat treatment had a lower average value and a larger variation in comparison with those after heat treatment than in Examples 1 to 6. In Example 7, the thickness of the magnetostrictive member being 3 mm, which exceeds 2 mm, it was estimated that the effect of modification of the above-described magnetostrictive characteristics by forming the grooves 2 extending in the long-side direction D1 in the magnetostrictive member was smaller than with the magnetostrictive member having a thickness of 2 mm or less. In Examples 5 to 7, compared to Examples 1 to 4, it was estimated that the dimension in the long-side direction and the dimension in the short-side direction also affected the force coefficient. Also in such a case of Example 7, it was found that the above-described modification effect almost equivalent to a thickness of 2 mm or less was obtained by performing the heat treatment after forming the grooves 2 extending in the longitudinal direction D1 in the magnetostrictive member. Therefore, it was found that the force coefficient that was stable at a high level was able to be obtained even for the magnetostrictive member with a thickness exceeding 2 mm. From the results of the examples, it is confirmed that the magnetostrictive member 1 of the present embodiment has characteristics including a high force coefficient and a small variation among members, and at the same time, a further reduced optimum magnetic field strength and a small variation. From the results of the examples, it is confirmed that the method for manufacturing a magnetostrictive member of an aspect of the present invention can easily manufacture a magnetostrictive member having a high force coefficient and a small variation among members, and at the same time, a reduced optimum magnetic field strength and a small variation.

The technical scope of the present invention is not limited to the aspects described in the embodiments and the like described above. One or more of the requirements described in the embodiments and the like described above may be omitted. The requirements described in the embodiments and the like described above can be combined as appropriate. To the extent permitted by law, the disclosure of Japanese Patent Application No. 2023-037128, which is a Japanese patent application, and all the references cited in the embodiments and the like described above is incorporated herein by reference.

For example, the above description describes an example of a magnetostrictive member having the grooves 2 extending in the long-side direction on at least one surface of the front surface and the back surface of the plate-shaped body, but the grooves 2 may be absent. For example, the magnetostrictive member may be a magnetostrictive member including a plurality of magnetostrictive members obtained from the same crystal, the magnetostrictive member being formed of a crystal of an iron-based alloy having magnetostrictive characteristics, and being a plate-shaped body having a long-side direction and a short-side direction, and the magnetostrictive members having a ratio (standard deviation/average value) of a standard deviation of optimum magnetic field strength to an average value of the optimum magnetic field strength determined by electromechanical equivalent circuit analysis of 0.2 or less, and having a ratio (standard deviation/average value) of a standard deviation of a force coefficient to an average value of the force coefficient determined by electromechanical equivalent circuit analysis of 0.3 or less. This configuration can provide large device output, further reduce the optimum magnetic field strength, and also reduce a variation in device characteristics when a magnetostrictive vibration power generation device is manufactured using the magnetostrictive member with a high parallel magnetostriction amount and a small variation in the parallel magnetostriction amount among members. This magnetostrictive member can be obtained by, for example, modification of the ratio (standard deviation/average value) of the standard deviation of the optimum magnetic field strength to the average value of the optimum magnetic field strength obtained by the electromechanical equivalent circuit analysis in the magnetostrictive member by the heat treatment.

Description of Reference Signs

1       Magnetostrictive member
2       Groove
3       Front surface
4       Back surface
D1      Long-side direction
D2      Short-side direction
S1      Crystal preparation step
S2      Crystal cutting step
S3      Groove forming step
S4      Cutting step
S5      Heat treatment step
S6      Groove re-forming step

**Claims**

1.  A magnetostrictive member comprising a plurality of magnetostrictive members obtained from a same crystal, the magnetostrictive member

    being formed of a crystal of an iron-based alloy having magnetostrictive characteristics,
    being a plate-shaped body having a long-side direction and a short-side direction, and
    having a plurality of grooves extending in the long-side direction on at least one surface of a front surface and a back surface of the plate-shaped body, and
    the magnetostrictive members having a ratio (standard deviation/average value) of a standard deviation of optimum magnetic field strength to an average value of the optimum magnetic field strength determined by electromechanical equivalent circuit analysis of 0.2 or less.

2. The magnetostrictive member according to claim 1, wherein the magnetostrictive members have a ratio (standard deviation/average value) of a standard deviation of a force coefficient to an average value of the force coefficient determined by electromechanical equivalent circuit analysis of 0.3 or less.

3. The magnetostrictive member according to claim 1, wherein the magnetostrictive members have a ratio (standard deviation/average value) of a standard deviation of a force coefficient to an average value of the force coefficient determined by electromechanical equivalent circuit analysis of 0.1 or less.

4. A magnetostrictive member comprising a plurality of magnetostrictive members obtained from a same crystal, the magnetostrictive member

   being formed of a crystal of an iron-based alloy having magnetostrictive characteristics, and
   being a plate-shaped body having a long-side direction and a short-side direction, and
   the magnetostrictive members having a ratio (standard deviation/average value) of a standard deviation of optimum magnetic field strength to an average value of the optimum magnetic field strength determined by electromechanical equivalent circuit analysis of 0.2 or less, and having a ratio (standard deviation/average value) of a standard deviation of a force coefficient to an average value of the force coefficient determined by electromechanical equivalent circuit analysis of 0.3 or less.

5. The magnetostrictive member according to any one of claims 1 to 4, wherein a thickness of the plate-shaped body is 0.3 mm or more and 5 mm or less.

6. A method for manufacturing the magnetostrictive member according to any one of claims 1 to 4, the method comprising:

   forming a plurality of grooves, on at least one surface of a front surface and a back surface of a plate-shaped body formed of a crystal of an iron-based alloy having magnetostrictive characteristics and having a long-side direction and a short-side direction, the grooves extending in the long-side direction; and
   performing heat treatment on the plate-shaped body provided with the grooves extending in the long-side direction.

7. The method for manufacturing a magnetostrictive member according to claim 6, comprising forming the grooves by surface grinding.

8. The method for manufacturing a magnetostrictive member according to claim 6, wherein a heat treatment temperature of the heat treatment is 400°C or higher and 700°C or lower.

9. The method for manufacturing a magnetostrictive member according to claim 6, wherein a retention time of the heat treatment is 5 hours or less.

10. The method for manufacturing a magnetostrictive member according to claim 6, comprising re-forming a plurality of grooves extending in the long-side direction on the plate-shaped body subjected to the heat treatment.

Fig. 1

Fig. 2

Fig. 3

IMPEDANCE
ANALYZER

MEASUREMENT
COIL

EXCITATION COIL

DC POWER SUPPLY

Fig. 4

MECHANICAL CIRCUIT      ELECTRIC CIRCUIT

Fig. 5

| CRYSTAL PREPARATION STEP | S1 |
| CRYSTAL CUTTING STEP | S2 |
| GROOVE FORMING STEP | S3 |
| CUTTING STEP | S4 |
| HEAT TREATMENT STEP | S5 |

Fig. 6

SINGLE CRYSTAL

FIRST {100} PLANE

THIRD <100> AXIS

SECOND <100> AXIS

FIRST <100> AXIS

THIN PLATE MEMBER

(a)

THIRD <100> AXIS

SECOND <100> AXIS

FIRST <100> AXIS

FIRST {100} PLANE

THIRD {100} PLANE

SECOND {100} PLANE

(b)

THIRD <100> AXIS

SECOND <100> AXIS

FIRST <100> AXIS

(c)

FIRST {100} PLANE

THIRD <100> AXIS

SECOND <100> AXIS

FIRST <100> AXIS

EP 4 680 000 A1

Fig. 7

```
┌─────────────────────────────────┐
│   CRYSTAL PREPARATION STEP      │─ S1
└─────────────────────────────────┘
                │
                ▼
┌─────────────────────────────────┐
│    CRYSTAL CUTTING STEP         │─ S2
└─────────────────────────────────┘
                │
                ▼
┌─────────────────────────────────┐
│    GROOVE FORMING STEP          │─ S3
└─────────────────────────────────┘
                │
                ▼
┌─────────────────────────────────┐
│         CUTTING STEP            │─ S4
└─────────────────────────────────┘
                │
                ▼
┌─────────────────────────────────┐
│    HEAT TREATMENT STEP          │─ S5
└─────────────────────────────────┘
                │
                ▼
┌─────────────────────────────────┐
│    GROOVE RE-FORMING STEP       │─ S6
└─────────────────────────────────┘
```

## INTERNATIONAL SEARCH REPORT

| International application No. |
|---|
| **PCT/JP2024/004133** |

| A. | CLASSIFICATION OF SUBJECT MATTER |
|---|---|

*H10N 35/80*(2023.01)i; *C30B 29/62*(2006.01)i; *C30B 33/00*(2006.01)i; *H10N 35/01*(2023.01)i
FI:   H10N35/80; C30B29/62 U; C30B33/00; H10N35/01

According to International Patent Classification (IPC) or to both national classification and IPC

| B. | FIELDS SEARCHED |
|---|---|

Minimum documentation searched (classification system followed by classification symbols)

    H10N35/80; C30B29/62; C30B33/00; H10N35/01

Documentation searched other than minimum documentation to the extent that such documents are included in the fields searched

    Published examined utility model applications of Japan 1922-1996
    Published unexamined utility model applications of Japan 1971-2024
    Registered utility model specifications of Japan 1996-2024
    Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2022-74526 A (SUMITOMO METAL MINING CO., LTD.) 18 May 2022 (2022-05-18) | 1 |
| |     paragraphs [0011], [0021]-[0023], [0029]-[0035], fig. 1 | |
| A | | 2-10 |
| Y | JP 2021-90263 A (PANASONIC INTELLECTUAL PROPERTY MANAGEMENT CO., LTD.) 10 June 2021 (2021-06-10) | 1, 6-9 |
| |     paragraphs [0010], [0048]-[0057], [0063]-[0072], [0077], [0078], fig. 3, 5, examples 1-1, 1-3 | |
| A | | 2-5, 10 |
| Y | WO 2021/100467 A1 (SUMITOMO METAL MINING CO., LTD.) 27 May 2021 (2021-05-27) | 6-9 |
| |     paragraphs [0011], [0051]-[0061], fig. 1(A)-2 | |
| A | | 1-5, 10 |

☑ Further documents are listed in the continuation of Box C.      ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 April 2024** | **23 April 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| --- |
| **PCT/JP2024/004133** |

**C.    DOCUMENTS CONSIDERED TO BE RELEVANT**

| Category* | Citation of document, with indication, where appropriate, of the relevant passages | Relevant to claim No. |
| --- | --- | --- |
| A | JP 2020-63997 A (NATIONAL UNIVERSITY CORPORATION KANAZAWA UNIV.) 23 April 2020 (2020-04-23)<br>    entire text, all drawings | 1-10 |

Form PCT/ISA/210 (second sheet) (July 2022)

**INTERNATIONAL SEARCH REPORT**
Information on patent family members

International application No.

**PCT/JP2024/004133**

| Patent document cited in search report | | | Publication date (day/month/year) | Patent family member(s) | Publication date (day/month/year) |
|---|---|---|---|---|---|
| JP | 2022-74526 | A | 18 May 2022 | (Family: none) | |
| JP | 2021-90263 | A | 10 June 2021 | (Family: none) | |
| WO | 2021/100467 | A1 | 27 May 2021 | JP 2022-78119 A <br> US 2023/0074828 A1 <br> paragraphs [0020], [0069]-[0079], fig. 1(A)-2 <br> EP 4064372 A1 <br> CN 114730826 A <br> KR 10-2022-0101096 A | |
| JP | 2020-63997 | A | 23 April 2020 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016028831 A
- JP 2016138028 A
- JP H4108699 A
- JP 2015517024 A
- WO 2021158473 A
- WO 2021100467 A
- JP 2020063997 A
- JP 2023037128 A

**Non-patent literature cited in the description**

- **ETREMA**. *State of the Art of Galfenol Processing*
- **A. E. CLARK et al.** *Appl. Phys.*, 2003, vol. 93, 8621
- **JUNG JIN PARK** ; **SUOK-MIN NA** ; **GANESH RAGHUNATH** ; **ALISON B. FLATAU.** *AIP Advances*, 2016, vol. 6, 056221
- **TOSHIYUKI UENO**. *Journal of the Japan Society for Precision Engineering*, 2013, vol. 79 (4), 305-308
- *Journal of Marine Acoustics Society of Japan*, 1997, vol. 24 (3)